# EUROPÄISCHE PATENTANMELDUNG

(11) **EP 0 813 069 A2**
(43) Veröffentlichungstag der Anmeldung: **17.12.1997**
(21) Anmeldenummer: 97109009.7
(22) Anmeldetag: 04.06.1997
(51) Int. Cl.: G01R 31/06, G01R 19/00

(54) **Vorrichtung zum Ermitteln des in einer Induktivität fliessenden Stroms**

(30) Priorität: 12.06.1996 DE 19623442
(71) Anmelder: TEMIC TELEFUNKEN microelectronic GmbH, 74072 Heilbronn (DE)
(72) Erfinder: Pollersbeck, Werner, 85104 Pförring (DE)
(74) Vertreter: Maute, Hans-Jürgen, Dipl.-Ing.

(57) **Zusammenfassung**

Eine Schaltungsanordnung mit einer Vorrichtung zum Ermitteln des in einer Induktivität fließenden mittleren Stroms, wobei die Induktivität mit ihrem einen Anschluß mit einem Pol einer Betriebsspannungsquelle zu koppeln ist und mit ihrem anderen Anschluß über einen getakteten elektronischen Schalter, z.B. einen Feldeffekttransistor, im Wechsel mit dem anderen Pol der Betriebsspannungsquelle verbindbar und von diesem trennbar ist, und wobei der Induktivität eine Freilaufdiode parallel geschaltet ist, ist dadurch gekennzeichnet, daß die Vorrichtung zum Ermitteln des Stroms einen zwischen den elektronischen Schalter und den anderen Pol eingeschalteten Shunt-Widerstand aufweist und eine Meßspannung, die dem an diesem durch den Strom erzeugten Spannungsabfall proportional ist, einer Auswertevorrichtung zuführt, und daß eine Vorrichtung zum hochohmigen Unterbrechen der Zufuhr der Meßspannung zur Auswertevorrichtung während der Zeitintervalle, in denen der elektronische Schalter gesperrt ist, vorgesehen ist. Dadurch ist ein einfacher aufbau mit relativ wenigen Schaltungselementen möglich.

## Beschreibung

Die Erfindung betrifft eine Schaltungsanordnung mit einer Vorrichtung zum Ermitteln des in einer Induktivität fließenden mittleren Stroms, wobei die Induktivität mit ihrem einen Anschluß mit einem Pol einer Betriebsspannungsquelle zu koppeln ist und mit ihrem anderen Anschluß über einen getakteten elektronischen Schalter, z.B. einen Feldeffekttransistor (FET), im Wechsel mit dem anderen Pol der Betriebsspannungsquelle verbindbar und von diesem trennbar ist, und wobei der Induktivität eine Freilaufdiode parallel geschaltet ist.

Solche Schaltungsanordnungen werden in der Kraftfahrzeugelektronik angewendet. Bei der Induktivität handelt es sich häufig um die Magnetspule eines elektromagnetischen Ventils, und über einen Microcontroller wird mittels Impulsbreitenmodulation die Einschaltdauer eines an Masse liegenden FET so eingestellt, daß sich in der Induktivität im zeitlichen Mittel der gewünschte Strom einstellt. Wenn der FET ausgeschaltet wird, fließt der Strom in der Induktivität infolge der Lenz'schen Regel in unveränderter Richtung weiter, und zum Schutz des FET ist eine Freilaufdiode vorgesehen. Ist der Strom durch die Induktivität zu groß, so kann diese schließlich überhitzt werden und Schaden nehmen. Zur Erwärmung der Induktivität trägt auch der Freilaufstrom bei. Die eingangs geschilderte Schaltungsanordnung kann daher vorteilhaft dazu verwendet werden, zu verhindern, daß die Induktivität durch einen zu hohen Strom überlastet wird.

Bei einer bekannten Anordnung ist ein Shunt-Widerstand zwischen der Induktivität und der Versorgungsspannung eingefügt, also auf derjenigen Seite des FET, der dem Masseanschluß abgewandt ist und die daher als "Highside" bezeichnet wird. Bei der bekannten Anordnung fließt der Strom bei leitendem FET wie auch der Freilaufstrom bei gesperrtem FET durch den Shunt-Widerstand, und es ist daher möglich, den Strom, der durch die Induktivität fließt, zu erfassen. Da der Shunt jedoch nicht an Masse liegt, ist eine aufwendige Schaltung, ein sogenannter Stromspiegel, erforderlich, um aus dem Spannungsabfall am Shunt ein auf Masse bezogenes, zum Iststrom durch die Spule proportionales Signal zu erzeugen, das dem Microcontroller über einen Analog-Digitalkonverter zugeführt werden kann.

Der Erfindung liegt die Aufgabe zugrunde, eine Schaltungsanordnung der eingangs geschilderten Art zu schaffen, die weniger aufwendig ist.

Diese Aufgabe wird gemäß der Erfindung dadurch gelöst, daß die Vorrichtung zum Ermitteln des Stroms einen zwischen den elektronischen Schalter und den anderen Pol eingeschalteten Shunt-Widerstand aufweist und eine Meßspannung, die dem an diesem durch den Strom erzeugten Spannungsabfall proportional ist, einer Auswertevorrichtung zuführt, und daß eine Vorrichtung zum hochohmigen Unterbrechen der Zufuhr der Meßspannung zur Auswertevorrichtung während der Zeitintervalle, in denen der elektronische Schalter gesperrt ist, vorgesehen ist.

Die Erfindung ermöglicht es, den Strom durch den FET auf einfache Weise mittels des Shunt-Widerstands zu erfassen, und hierzu sind nur wenige Bauteile und insbesondere kein aufwendiger Stromspiegel erforderlich. Würde man allerdings die aus dem Spannungsabfall am Shunt abgeleitete Meßspannung, die insbesondere durch einen Operationsverstärker verstärkt sein kann, unmittelbar einer Auswertevorrichtung, beispielsweise einem Tiefpaß mit nachgeschaltetem Analog-Digital-Wandler zuführen, so würde in denjenigen Zeitintervallen der Taktung des FET (ständiges Umschalten zwischen leitendem und nichtleitendem Zustand), in denen der FET leitet, eine von Null verschiedene Meßspannung vorhanden sein, bei gesperrtem FET jedoch den Wert 0 haben. Eine Glättung eines derart stark welligen Signal wäre einerseits sehr aufwendig, andererseits würde eine Glättung jedoch auch eine hohe Zeitkonstante erfordern, die eine schnelle Ermittlung des Stroms in der Induktivität zwecks rascher Regelung verhindern würde. Bei der Erfindung wird nun in denjenigen Zeitintervallen, in denen der FET gesperrt ist, die Zufuhr der Meßspannung zur Auswertevorrichtung hochohmig unterbrochen; ein Absinken der an der Auswerteschaltung herrschenden Spannung während der Zeiten dieser Unterbrechung führt daher nur insoweit zu einem Absinken der Spannung an der Auswerteschaltung, wie sie durch die endlichen Widerstände der Auswerteschaltung und sonstiger Komponenten sich ergibt, und daher ist die Welligkeit dieses gemäß der Erfindung der Auswertevorrichtung zugeführten Signals sehr viel kleiner als ohne die geschilderte Unterbrechung. Daher kann dieses Signal mit einfachen Mitteln und mit kurzer Zeitkonstante geglättet werden.

Die Unterbrechung der Zufuhr der Meßspannung zur Auswertevorrichtung kann in einfacher Weise durch einen sogenannten Analogschalter, nämlich ein Halbleiterbauelement erfolgen. Es kann sich hierbei um einen Transistor handeln, der im durchgeschalteten Zustand nur einen sehr geringen Widerstand aufweist. Der Ansteueranschluß dieses Analogschalters kann in besonders einfacher Weise mit dem Gate-Anschluß des Leistungs-FET gekoppelt sein. Es erscheint aber auch möglich, die Ansteuerung in Abhängigkeit von der an dem Shunt-Widerstand auftretenden impulsförmigen Spannung vorzunehmen, und in diesem Fall wäre die Vorrichtung zum Ermitteln des in der Induktivität fließenden, gemittelten Stroms eingangsseitig nur an den Shunt-Widerstand anzuschließen.

Bei der erfindungsgemäßen Vorrichtung wird der Strom durch die Induktivität bei gesperrtem FET nicht meßtechnisch erfaßt. Dieser Strom hat einen anderen zeitlichen Verlauf als der Strom durch die Induktivität bei leitendem FET, insbesondere ist wegen der Verluste, insbesondere auch durch die Freilaufdiode, das Zeitintegral über den Strom durch die Induktivität bei leitendem FET größer als bei gesperrtem FET.

Um in der Auswertevorrichtung ein Signal erzeugen zu können, das der Summe der Ströme bei leitendem FET und bei gesperrtem FET durch die Induktivität (über die Zeit gemittelt) möglichst nahe kommt, ist gemäß einer Ausführungsform der Erfindung vorgesehen, daß zwischen den Eingang des Tiefpasses und den anderen Pol der Betriebsspannungsquelle (insbesondere Masse) ein Widerstand zwecks Verringerung der dem Tiefpaß zugeführten Meßspannung eingeschaltet ist. Es handelt sich hier um eine Fehlerkorrektur mittels Analogtechnik. Wenn man annimmt, daß die Dauer der stromleitenden Intervalle des FET sehr viel größer ist als die Dauer der Sperrzeiten des FET, so wirkt sich die Nichterfassung des Freilaufstroms (Strom durch die Freilaufdiode) nicht sehr stark aus; sind dagegen die Sperrzeiten des FET relativ groß, so ist der Fehler größer, weil nämlich die gemittelte Spannung an der Auswertevorrichtung kleiner sein müßte als sie durch die hochohmige Sperrung gemäß der Erfindung tatsächlich ist. Der geschilderte Widerstand, der parallel zum Eingang des Tiefpasses geschaltet ist, sorgt für eine Verringerung der Spannung am Eingang des Tiefpasses, und zwar um so mehr, je länger die hochohmige Unterbrechung, die oben beschrieben wurde, dauert. Bei nur kurzzeitigen hochohmigen Unterbrechungen wirkt sich dieser Widerstand weniger stark aus.

Statt einer solchen analogen Korrektur mittels eines Widerstands oder auch zusätzlich kann eine rechnerische Korrektur, insbesondere durch digitale Rechnung mittels eines Microcontrollers erfolgen. Die geschilderten Korrekturen erlauben es, für die erfindungsgemäße Vorrichtung relativ grob tolerierte Bauelemente zu wählen. Die hierdurch auftretenden Fehler oder Ungenauigkeiten können durch die geschilderten Korrekturmaßnahmen zumindest zum großen Teil kompensiert werden. Auch hierdurch wird es möglich, die erfindungsgemäße Vorrichtung äußerst einfach und mit geringeren Kosten aufzubauen. Demgegenüber wird bei der eingangs geschilderten bekannten Schaltungsanordnung die erforderliche Genauigkeit durch entsprechend enge Tolerierung der Bauelemente gewährleistet, wodurch die Kosten steigen.

Bei der rechnerischen Korrektur können die Korrekturwerte in Abhängigkeit von unterschiedlichen mittleren Strömen durch die Induktivität, entsprechend unterschiedlichen Impulsbreiten der Leitfähigkeitsintervalle des FET, in einem nicht flüchtigen Speicher abgelegt werden und somit in Form einer elektronischen Tabelle zur Korrektur der Meßergebnisse herangezogen werden. Dabei werden die Korrekturwerte für jede einzelne fertiggestellte Schaltung ermittelt, so daß die Toleranzen der Schaltung berücksichtigt werden.

Nach den derzeitigen Erkenntnissen sind die geschilderten Korrekturen insbesondere dann recht zuverlässig, wenn das Verhältnis des Induktivitätswerts L der Induktivität (zum Beispiel Ventilspule) zu ihrem ohmschen Widerstand R in einem bestimmten Tastverhältnisbereich (zum Beispiel Impulspause kleiner als 20%, je nach dem Verhältnis L:R) der Fehler in einem für den geschilderten Anwendungsfall akzeptablen Bereich liegt, nämlich unterhalb von 7%. Die geschilderten Korrekturen durch den Widerstand am Eingang des Tiefpasses beziehungsweise die rechnerische Korrektur verringern den soeben genannten Fehler noch.

Weitere Merkmale und Vorteile ergeben sich aus der nachfolgenden Beschreibung eines Ausführungsbeispiels der Erfindung anhand der Zeichnung, die erfindungswesentliche Einzelheiten zeigt, und aus den Ansprüchen. Die einzelnen Merkmale können je einzeln für sich oder zu mehreren in beliebiger Kombination bei einer Ausführungsform der Erfindung verwirklicht sein. Es zeigen
- Fig. 1: ein Prinzipschaltbild einer erfindungsgemäßen Vorrichtung,
- Fig. 2: Signalverläufe in Abhängigkeit von der Zeit, und
- Fig. 3: die Prinzipschaltung einer bekannten Schaltungsanordnung mit Stromspiegel.

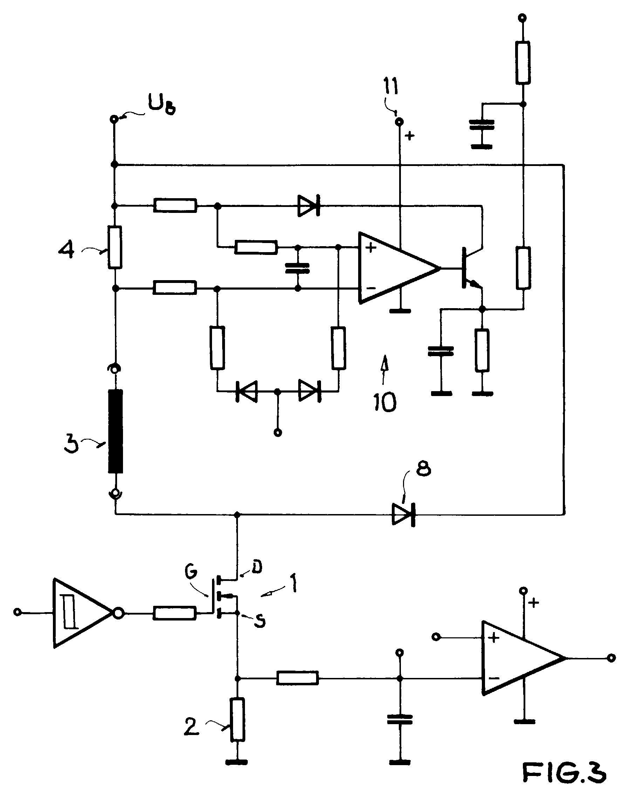

Figur 3 zeigt eine im Prinzip bekannte Schaltungsanordnung. Ein Leistungs-Feldeffekttransistor, nachfolgende FET 1 genannt, ist mit seinem Source-Anschluß mit dem einen Anschluß eines für die Stromerfassung zwecks Kurzschlußfeststellung dienenden Widerstands 2 verbunden, dessen anderer Anschluß an Masse liegt. Der Drain-Anschluß D des FET 1 ist mit dem einen Anschluß einer Induktivität 3 verbunden, deren anderer Anschluß unter anderem mit einem zur Stromerfassung des Stroms durch die Induktivität 3 dienenden Meßshunt 4 verbunden ist. Dessen anderer Anschluß ist unter anderem über eine Einrichtung zur Kurzschlußabschaltung 5, zu der ein von dieser gesteuerter FET 6 gehört, über eine Verpolungsschutzdiode 7 mit dem positiven Pol der Versorgungsspannungsquelle verbunden, deren anderer Anschluß mit Masse verbunden ist. Eine Freilaufdiode 8 ist zwischen den dem FET 1 zugewandten Anschluß der Induktivität 3 und den der Induktivität 3 abgewandten Anschluß des Meßshunts 4 geschaltet. Der FET 1 wird impulsbreitenmoduliert gesteuert.

Da der Meßshunt 4 nicht an Masse liegt, wird zur Erzeugung eines auf Masse bezogenen Meßsignals eine aufwendige Stromspiegelschaltung 10 verwendet, die hier nicht näher erläutert wird. Die Stromspiegelschaltung 10 benötigt zu ihrem Betrieb eine oberhalb der Versorgungsspannung liegende Betriebsspannung, die durch eine an einen Anschluß 11 anzuschließende Ladungspumpe, die eine erhöhte Spannung mittels Kondensatoraufladung erzeugt, aus der Versorgungsspannung gebildet wird.

Bei dieser bekannten Schaltung wird sowohl der vom FET 1 durch die Induktivität 3 geleitete Strom als auch nach dem Sperren des FET 1 von der Induktivität 3 durch die Freilaufdiode 8 hindurch erzeugte Strom von dem Meßshunt 4 erfaßt und somit gemessen.

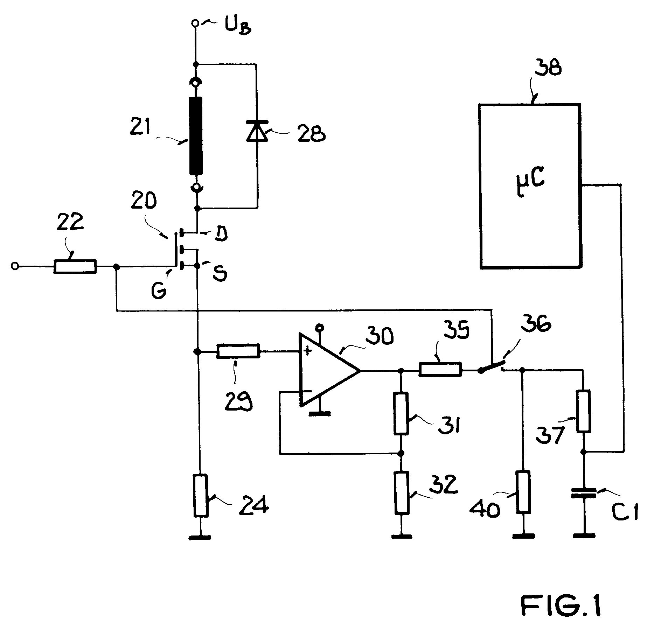

In Figur 1 ist ein Beispiel einer erfindungsgemäßen Schaltung gezeigt. Zwar haben zahlreiche Komponenten eine ähnliche Funktion wie in Figur 3, es ist jedoch bei der Vergabe der Bezugszeichen nicht darauf geachtet worden, mit dem Bezugszeichen der Figur 3 ähnliche Bezugszeichen zu wählen.

Ein Leistungs-Feldeffekttransistor, nachfolgend FET 20 genannt, dient dazu, den Strom durch eine Induktivität 21, bei der es sich um die Magnetspule eines elektromagnetisch betätigten Ventils handeln mag, getaktet einzuschalten und auszuschalten. Die hierfür erforderliche Ansteuerspannung für den Gate-Anschluß des FET 20 wird über einen Vorwiderstand 22 dem genannten Gate-Anschluß zugeführt und mag von einem Microcontroller erzeugt werden. Es kann sich hierbei insbesondere um eine Folge von impulsbreitenmodulierten Impulsen handeln, wobei durch deren Modulation der über die Zeit gemittelte Strom durch die Induktivität 21 geändert werden kann.

Der Source-Anschluß S des FET 20 ist über einen Shunt-Widerstand 24 mit Masse verbunden, der Drain-Anschluß D des FET 20 ist mit dem einen Anschluß der genannten Induktivität 21 verbunden, deren anderer Anschluß wiederum über eine Schaltung zur Kurzschlußabschaltung und eine Verpolungsschutzdiode 26 mit dem positiven Pol der Versorgungsspannungsquelle UB verbunden ist, deren negativer Anschluß mit Masse verbunden ist. Eine Freilaufdiode 28 ist mit den beiden Anschlüssen der Induktivität 21 verbunden. Ein Kondensator C1 ist zwischen den Drain-Anschluß und Masse eingeschaltet. Ein Kondensator C2 ist an der Verbindungsstelle der Verpolungsschutzdiode 26 mit der dem FET 24, der von der Kurzschlußabschaltung gesteuert wird, und Masse angeschlossen.

Der dem Masseanschluß abgewandte Anschluß des Shunt-Widerstand 24 ist mit dem nicht-invertierenden Eingang eines Operationsverstärkers 30 verbunden, dessen Ausgangssignal über einen Spannungsteiler aus den Widerständen 31 und 32, durch die die Verstärkung des Operationsverstärkers eingestellt wird, auf den invertierenden Eingang des Operationsverstärkers zurückgeführt ist. Der Operationsverstärker wird von einer Versorgungsspannung versorgt. Der Ausgang des Operationsverstärkers ist auch über einen Schutzwiderstand 35 mit einem Eingang eines Analogschalters 36 verbunden, dessen Ausgang dem Eingang eines Glättungstiefpasses, gebildet aus einem Serienwiderstand 37 und einem von dessen Ausgang nach Masse verbundenen Kondensator C3, zugeführt wird. Der Ausgang des Glättungstiefpasses wird durch den Verbindungspunkt des Widerstands 37 mit dem Kondensator C3 gebildet und wird bei der speziellen Anwendung der in Figur 1 gezeigten Schaltung dem Analog/Digital-Umsetzereingang eines Microcontrollers 38 zugeführt, der dieses Signal auswertet und die ganze Schaltungsanordnung steuert und insbesondere das Ansteuersignal für den FET 20 erzeugt.

Zwischen den Eingang des Glättungstiefpasses und Masse ist ein Korrekturwiderstand 40 eingeschaltet, der eine Absenkung des am Ausgang des Glättungstiefpasses erscheinenden Signals bewirkt, und zwar im Verhältnis um so stärker, je länger die Sperrzeiten des Analogschalters 36 sind.

Ein Steuereingang des Analogschalters 36 ist mit dem Gate-Anschluß des FET 20 verbunden und wird somit durch das gleiche Steuersignal gesteuert, das auch diesen FET 20 steuert. Der Analogschalter 36 ist dann leitend, wenn der FET 20 leitend ist, und der Analogschalter ist hochohmig gesperrt, wenn der FET 20 gesperrt ist.

Wenn der Spannungsabfall am Shunt-Widerstand 24 einen vorbestimmten Wert überschreitet, so wird dies als Kurzschluß interpretiert und die Kurzschlußabschaltung 25 bewirkt das Sperren des FET 24. Zu diesem Zweck wird das Ausgangssignal des Operationsverstärkers 30 der Vorrichtung 25 zugeführt. In der konkreten technischen Anwendung ist eine Vielzahl von gleichartigen Schaltungen, wie sie in Figur 1 gezeigt ist, zur Versorgung zahlreicher elektromagnetischer Ventile vorgesehen; wenn auch nur bei einer einzigen dieser Vielzahl von Schaltungen ein Kurzschluß auftritt, wird in allen diesen Schaltungen der Strom abgeschaltet. Wegen des Vorhandenseins mehrerer solcher Schaltungen ist die Verbindung vom Ausgang des jeweiligen Operationsverstärkers zur Vorrichtung 25, die insgesamt nur ein einziges Mal vorhanden ist, unter Zwischenschaltung jeweils einer Diode 42 vorgenommen, um die Ausgänge der verschiedenen Operationsverstärker 30 und die Weiterverarbeitung der von diesen gelieferten Signale durch die Glättungstiefpässe voneinander zu entkoppeln.

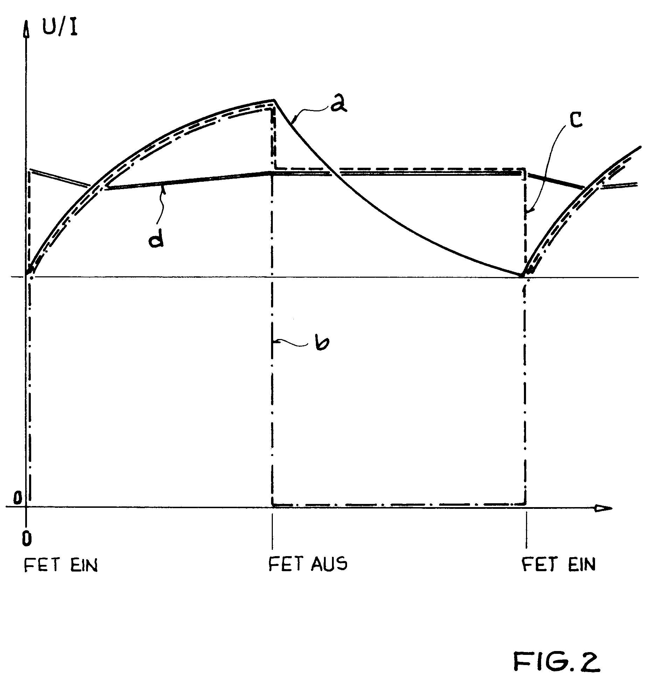

Figur 2 zeigt verschiedene Kurvenverläufe von Spannungen der erfindungsgemäßen Schaltung. Auf der waagrechten Achse, der Zeitachse, sind Zeitpunkte eingezeichnet, zu denen der FET 20 eingeschaltet wird, anschließend ausgeschaltet wird und wiederum eingeschaltet wird.

Die Kurve a zeigt den Strom in der Induktivität 21. Die beiden Zweige der Kurve für den eingeschalteten FET 20 einerseits und für den ausgeschalteten FET 20 andererseits sind verschieden, und das Stromintegral über die Zeit für den jeweiligen Zweig ist ungleich.

Der Spannungsabfall am Shunt-Widerstand 24 ist der Kurve b proportional. Diese fällt in den Sperrzeiten des FET 20 auf 0 ab und weist daher eine sehr starke Welligkeit auf, die sich für den speziellen Anwendungsfall nicht glätten läßt.

Die Kurve c zeigt den Spannungsverlauf am Eingang des Glättungstiefpasses, also hinter dem Analogschalter 36. Man erkennt, daß ein Abfall auf 0 nicht mehr vorhanden ist, die Spannung weist daher eine sehr viel geringere Welligkeit auf und läßt sich leicht glätten. Die Kurve c in demjenigen Zeitintervall, in dem der FET 20 ausgeschaltet ist, wird nur in seltenen Fällen einen Mittelwert haben, der dem Mittelwert des Stroms bei ausgeschaltetem FET durch die Induktivität 21 gleich ist. Normalerweise wird jedoch eine Abweichung vorhanden sein, und dieser Fehler wird in der bereits oben beschriebenen Weise durch den Widerstand 40 zumindest annähernd korrigiert oder kann auch durch digital ausgeführte Rechenvorgänge korrigiert werden.

Die Kurve d zeigt den Verlauf der Spannung am Ausgang des Tiefpasses 37, C3, die der Auswertevorrichtung, nämlich dem Microcontroller 38 zugeführt wird.

Der FET 20 und der Shunt-Widerstand 24 sind zwischen der Induktivität 21 und Masse angeordnet, was im Gegensatz zu Fig. 3 ist und als "Lowside-Anordnung" bezeichnet wird.

Der Analogschalter 36 ist vom Typ HC4066, der Operationsverstärker 30 vom Typ LM2902.

## Patentansprüche

1. Schaltungsanordnung mit einer Vorrichtung zum Ermitteln des in einer Induktivität (21) fließenden mittleren Stroms, wobei die Induktivität (21) mit ihrem einen Anschluß mit einem Pol einer Betriebsspannungsquelle (U_{B}) zu koppeln ist und mit ihrem anderen Anschluß über einen getakteten elektronischen Schalter (20), z.B. einen Feldeffekttransistor (FET), im Wechsel mit dem anderen Pol der Betriebsspannungsquelle (Masse) verbindbar und von diesem trennbar ist, und wobei der Induktivität (21) eine Freilaufdiode (28) parallel geschaltet ist, wobei die Vorrichtung zum Ermitteln des Stroms einen zwischen den elektronischen Schalter (20) und den anderen Pol (Masse) eingeschalteten Shunt-Widerstand (24) aufweist und eine Meßspannung, die dem an diesem durch den Strom erzeugten Spannungsabfall proportional ist, einer Auswertevorrichtung (38) zuführt, **dadurch gekennzeichnet, daß** die Meßspannung der Auswertevorrichtung (38) über einen Tiefpaß (37, C1) zugeführt wird, der eine arithmetische Mittelung der Meßspannung über die Zeit hinweg durchführt, wobei jeweils während der Zeitintervalle, in denen der elektronische Schalter (20) gesperrt ist, die Zufuhr der Meßspannung zum Tiefpaß (37, C1) mittels einer entsprechend angesteuerten Vorrichtung zum hochohmigen Unterbrechen der Zufuhr der Meßspannung (36) unterbrochen wird.

2. Schaltungsanordnung nach Anspruch 1, **dadurch gekennzeichnet, daß** zwischen den Eingang des Tiefpasses (37, C1) und den anderen Pol der Betriebsspannungsquelle (Masse) ein Widerstand (40) zwecks Verringerung der dem Tiefpaß (37, C1) zugeführten Meßspannung eingeschaltet ist.

3. Schaltungsanordnung nach Anspruch 1 oder 2, **dadurch gekennzeichnet, daß** dem Tiefpaß (37, C1) eine Einrichtung zur rechnerischen Korrektur der Meßspannung nachgeschaltet ist.

4. Schaltungsanordnung nach einem der vorhergehenden Ansprüche, **dadurch gekennzeichnet, daß** die Vorrichtung zum hochohmigen Unterbrechen ein Analogschalter ist.

5. Schaltungsanordnung mit einer Vorrichtung zum Ermitteln des in einer ohmschen Last fließenden mittleren Stroms, wobei die ohmsche Lastmit ihrem einen Anschluß mit einem Pol einer Betriebsspannungsquelle (U_{B}) zu koppeln ist und mit ihrem anderen Anschluß über einen getakteten elektronischen Schalter (20), z.B. einen Feldeffekttransistor (FET), im Wechsel mit dem anderen Pol der Betriebsspannungsquelle (Masse) verbindbar und von diesem trennbar ist, und wobei der Induktivität (21) eine Freilaufdiode (28) parallel geschaltet ist, wobei die Vorrichtung zum Ermitteln des Stroms einen zwischen den elektronischen Schalter (20) und den anderen Pol (Masse) eingeschalteten Shunt-Widerstand (24) aufweist und eine Meßspannung, die dem an diesem durch den Strom erzeugten Spannungsabfall proportional ist, einer Auswertevorrichtung (38) zuführt, **dadurch gekennzeichnet, daß** die Meßspannung der Auswertevorrichtung (38) über einen Tiefpaß (37, C1) zugeführt wird, der eine arithmetische Mittelung der Meßspannung über die Zeit hinweg durchführt, wobei jeweils während der Zeitintervalle, in denen der elektronische Schalter (20) gesperrt ist, die Zufuhr der Meßspannung zum Tiefpaß (37, C1) mittels einer entsprechend angesteuerten Vorrichtung zum hochohmigen Unterbrechen der Zufuhr der Meßspannung (36) unterbrochen wird.
